# EUROPEAN PATENT APPLICATION

(11) **EP 4 550 061 A1**
(43) Date of publication of application: **07.05.2025**
(21) Application number: 24208146.1
(22) Date of filing: 22.10.2024
(51) Int. Cl.: G05B 9/02, H02P 29/024

(54) **SAFETY STATUS MONITORING SYSTEM AND METHOD FOR MOTOR DRIVE CONTROL SYSTEM**

(30) Priority: 30.10.2023 CN 202311418392
(71) Applicant: ZF Friedrichshafen AG, 88046 Friedrichshafen (DE)
(72) Inventor: Jiang, Max, Shanghai, 201615 (CN); Han, Chang, Shanghai, 201615 (CN); XU, Yang, Shanghai, 201615 (CN)
(74) Representative: ZF Friedrichshafen AG

(57) **Abstract**

The present invention provides a safety status monitoring system and method for a motor drive control system. The safety status monitoring system includes: a master control chip configured to issue a master control chip hardware failure signal; a power management chip; a bus voltage comparison module; a three-phase bridge switching circuit module; a safety control logic generation module configured to generate a hardware failure mode enable signal and a hardware failure status control signal based on the master control chip hardware failure signal, a safety status entry signal, and a safety status switching signal for a motor drive control system; a gate drive module configured to generate a gate drive signal based on the hardware failure mode enable signal and the hardware failure status control signal to perform turning-on and turning-off operations on power transistors in the three-phase bridge switching circuit module; and a drive safety status monitoring module configured to generate a drive safety status feedback control signal based on the hardware failure mode enable signal, the hardware failure status control signal, a gate drive module failure status signal, and a power transistor working status signal.

## Description

### Technical Field

The present invention relates mainly to power electronics technologies, and in particular, to a safety status monitoring system and method for a motor drive control system.

### Background Art

During operation of a motor drive control system, such as a motor drive control system of an automobile, a fail safe mode is required in the event of a failure. For different types of failures, different failure handling methods need to be set up to cover corresponding failure situations so that the system remains in a safety status as much as possible in the event of a failure. For such a serious hardware failure in the motor drive control system, for example a failure in a master control chip, special failure handling is required so that the motor drive control system can still have as high a factor of safety as possible in this case, thereby reducing the risk to a user of the system. Therefore, how to perform safety status monitoring when a hardware failure occurs in the motor drive control system is a problem to be solved.

### Summary of the Invention

The technical problem to be solved in the present invention is to provide a safety status monitoring system and method for a motor drive control system, which enable the motor drive control system to be maintained in a safety status with a high factor of safety in the event of a hardware failure therein, thereby reducing the safety risk to a user of the system.

In order to solve the above technical problem, the present invention provides a safety status monitoring system for a motor drive control system. The safety status monitoring system includes: a master control chip including a hardware safety management unit configured to issue a master control chip hardware failure signal based on specific signal detection and determination logic; a power management chip configured to generate a safety status entry signal; a bus voltage comparison module configured to obtain a safety status switching signal for the motor drive control system; a three-phase bridge switching circuit module including a plurality of power transistors; a safety control logic generation module configured to generate a hardware failure mode enable signal and a hardware failure status control signal based on the master control chip hardware failure signal, the safety status entry signal, and the safety status switching signal for the motor drive control system; a gate drive module configured to generate a gate drive signal based on the hardware failure mode enable signal and the hardware failure status control signal to perform turning-on and turning-off operations on the power transistors in the three-phase bridge switching circuit module, and output a gate drive module failure status signal and a power transistor working status signal; and a drive safety status monitoring module configured to generate a drive safety status feedback control signal based on the hardware failure mode enable signal, the hardware failure status control signal, the gate drive module failure status signal, and the power transistor working status signal, and transmit the drive safety status feedback control signal to the safety control logic generation module.

In an embodiment of the present invention, the safety control logic generation module is further configured to update the hardware failure status control signal based on the drive safety status feedback control signal.

In an embodiment of the present invention, the three-phase bridge switching circuit module includes an upper three-bridge-arm circuit and a lower three-bridge-arm circuit; and each bridge arm of the upper three-bridge-arm circuit and the lower three-bridge-arm circuit includes a power transistor.

In an embodiment of the present invention, the generating a hardware failure mode enable signal and a hardware failure status control signal based on the master control chip hardware failure signal, the safety status entry signal, and the safety status switching signal for the motor drive control system includes: when the safety control logic generation module determines, based on the received master control chip hardware failure signal and safety status entry signal, that a hardware failure and/or a power supply failure occurs in the master control chip, generating, by the safety control logic generation module and based on a relationship between a bus voltage value of the motor drive control system and a set voltage threshold, the hardware failure mode enable signal and the hardware failure status control signal corresponding to turning off all the power transistors in the three-phase bridge switching circuit module or turning on all power transistors in the lower three-bridge-arm circuit of the three-phase bridge switching circuit module.

In an embodiment of the present invention, the set voltage threshold includes a first set voltage threshold and a second set voltage threshold, and the second set voltage threshold is greater than the first set voltage threshold; when the bus voltage value of the motor drive control system is less than the first set voltage threshold, the safety control logic generation module generates the hardware failure status control signal corresponding to turning off all the power transistors in the three-phase bridge switching circuit module; when the bus voltage value of the motor drive control system is greater than the second set voltage threshold, the safety control logic generation module generates the hardware failure status control signal corresponding to turning on all the power transistors in the lower three-bridge-arm circuit of the three-phase bridge switching circuit module; and a numerical interval between the first set voltage threshold and the second set voltage threshold is a hysteresis interval.

In an embodiment of the present invention, the generating a drive safety status feedback control signal based on the hardware failure mode enable signal, the hardware failure status control signal, the gate drive module failure status signal, and the power transistor working status signal includes: when the drive safety status monitoring module determines, based on the gate drive module failure status signal and power transistor working status signal of a current cycle, that the three-phase bridge switching circuit module does not enter a safety status corresponding to the hardware failure status control signal of a previous clock cycle, updating the hardware failure status control signal based on the gate drive module failure status signal and power transistor working status signal of the current cycle, to generate the drive safety status feedback control signal.

In an embodiment of the present invention, the updating the hardware failure status control signal of the current cycle based on the gate drive module failure status signal and power transistor working status signal of the current cycle includes: when the hardware failure status control signal of the previous clock cycle is the hardware failure status control signal corresponding to turning off all the power transistors in the three-phase bridge switching circuit module, and when the drive safety status monitoring module determines, based on the gate drive module failure status signal and power transistor working status signal of the current cycle, that the three-phase bridge switching circuit module does not enter a safety status corresponding to turning off all the power transistors in the three-phase bridge switching circuit module, updating the hardware failure status control signal based on the gate drive module failure status signal and power transistor working status signal of the current cycle, to generate, as the drive safety status feedback control signal, the hardware failure status control signal corresponding to turning on all power transistors in the upper three-bridge-arm circuit or the lower three-bridge-arm circuit of the three-phase bridge switching circuit module.

In an embodiment of the present invention, the updating the hardware failure status control signal based on the gate drive module failure status signal and power transistor working status signal of the current cycle, to generate, as the drive safety status feedback control signal, the hardware failure status control signal corresponding to turning on all power transistors in the upper three-bridge-arm circuit or the lower three-bridge-arm circuit of the three-phase bridge switching circuit module includes: when a short circuit failure occurs in a power transistor of one bridge arm in the upper three-bridge-arm circuit of the three-phase bridge switching circuit module, generating, as the drive safety status feedback control signal, the hardware failure status control signal corresponding to turning on all the power transistors in the upper three-bridge-arm circuit of the three-phase bridge switching circuit module.

In an embodiment of the present invention, the updating the hardware failure status control signal based on the gate drive module failure status signal and power transistor working status signal of the current cycle, to generate, as the drive safety status feedback control signal, the hardware failure status control signal corresponding to turning on all power transistors in the upper three-bridge-arm circuit or the lower three-bridge-arm circuit of the three-phase bridge switching circuit module includes: when a short circuit failure occurs in a power transistor of one bridge arm in the lower three-bridge-arm circuit of the three-phase bridge switching circuit module, generating, as the drive safety status feedback control signal, the hardware failure status control signal corresponding to turning on all the power transistors in the lower three-bridge-arm circuit of the three-phase bridge switching circuit module.

In an embodiment of the present invention, the updating the hardware failure status control signal based on the gate drive module failure status signal and power transistor working status signal of the current cycle, to generate, as the drive safety status feedback control signal, the hardware failure status control signal corresponding to turning on all power transistors in the upper three-bridge-arm circuit or the lower three-bridge-arm circuit of the three-phase bridge switching circuit module further includes: when the three-phase bridge switching circuit module cannot to enter the status for turning on all the power transistors in the upper three-bridge-arm circuit of the three-phase bridge switching circuit module due to an open circuit failure in the power transistor of one bridge arm in the upper three-bridge-arm circuit of the three-phase bridge switching circuit module, generating, as the drive safety status feedback control signal, the hardware failure status control signal corresponding to turning on all the power transistors in the lower three-bridge-arm circuit of the three-phase bridge switching circuit module.

In an embodiment of the present invention, the updating the hardware failure status control signal based on the gate drive module failure status signal and power transistor working status signal of the current cycle, to generate, as the drive safety status feedback control signal, the hardware failure status control signal corresponding to turning on all power transistors in the upper three-bridge-arm circuit or the lower three-bridge-arm circuit of the three-phase bridge switching circuit module further includes: when the three-phase bridge switching circuit module cannot to enter the status for turning on all the power transistors in the lower three-bridge-arm circuit of the three-phase bridge switching circuit module due to an open circuit failure in the power transistor of one bridge arm in the lower three-bridge-arm circuit of the three-phase bridge switching circuit module, generating, as the drive safety status feedback control signal, the hardware failure status control signal corresponding to turning on all the power transistors in the upper three-bridge-arm circuit of the three-phase bridge switching circuit module.

In an embodiment of the present invention, the updating the hardware failure status control signal based on the gate drive module failure status signal and power transistor working status signal of the current cycle, to generate, as the drive safety status feedback control signal, the hardware failure status control signal corresponding to turning on all power transistors in the upper three-bridge-arm circuit or the lower three-bridge-arm circuit of the three-phase bridge switching circuit module includes: when a short circuit failure occurs in a power transistor of one bridge arm in the upper three-bridge-arm circuit of the three-phase bridge switching circuit module and when a short circuit failure occurs in a power transistor of one bridge arm in the lower three-bridge-arm circuit of the three-phase bridge switching circuit module, maintaining the current hardware failure status control signal as the drive safety status feedback control signal.

In an embodiment of the present invention, the updating the hardware failure status control signal of the current cycle based on the gate drive module failure status signal and power transistor working status signal of the current cycle includes: when the hardware failure status control signal of the previous clock cycle is the hardware failure status control signal corresponding to turning on all the power transistors in the lower three-bridge-arm circuit of the three-phase bridge switching circuit module, and when the drive safety status monitoring module determines, based on the gate drive module failure status signal and power transistor working status signal of the current cycle, that the three-phase bridge switching circuit module does not enter a safety status corresponding to turning on all the power transistors in the lower three-bridge-arm circuit of the three-phase bridge switching circuit module, updating the hardware failure status control signal as the drive safety status feedback control signal based on the gate drive module failure status signal and power transistor working status signal of the current cycle.

In an embodiment of the present invention, the updating the hardware failure status control signal as the drive safety status feedback control signal based on the gate drive module failure status signal and power transistor working status signal of the current cycle includes: when an open circuit failure occurs in a power transistor of one bridge arm in the lower three-bridge-arm circuit of the three-phase bridge switching circuit module, generating, as the drive safety status feedback control signal, the hardware failure status control signal corresponding to turning on all the power transistors in the upper three-bridge-arm circuit of the three-phase bridge switching circuit module.

In an embodiment of the present invention, the drive safety status monitoring module is configured to generate the drive safety status feedback control signal after a specific time interval and based on the hardware failure mode enable signal, the hardware failure status control signal, the gate drive module failure status signal, and the power transistor working status signal, and transmit the drive safety status feedback control signal to the safety control logic generation module.

In an embodiment of the present invention, the gate drive module failure status signal corresponding to the three-phase bridge switching circuit module includes: a gate drive module failure status signal for a failed drive component corresponding to the upper three-bridge-arm circuit or the lower three-bridge-arm circuit of the three-phase bridge switching circuit module.

In an embodiment of the present invention, the power transistor working status signal is generated based on a turn-on voltage detection value of the power transistor.

The present invention further provides a safety status monitoring method for a motor drive control system. The method includes: issuing a master control chip hardware failure signal based on specific signal detection and determination logic; generating a safety status entry signal; obtaining a safety status switching signal for the motor drive control system; generating a hardware failure mode enable signal and a hardware failure status control signal based on the master control chip hardware failure signal, the safety status entry signal, and the safety status switching signal for the motor drive control system; generating a gate drive signal based on the hardware failure mode enable signal and the hardware failure status control signal to perform turning-on and turning-off operations on power transistors in a three-phase bridge switching circuit module, and outputting a gate drive module failure status signal and a power transistor working status signal; and generating a drive safety status feedback control signal based on the hardware failure mode enable signal, the hardware failure status control signal, the gate drive module failure status signal, and the power transistor working status signal.

In an embodiment of the present invention, the safety status monitoring method for a motor drive control system further includes: updating the hardware failure status control signal based on the drive safety status feedback control signal.

Compared with the prior art, the present invention has the following advantages. In the event of a hardware failure in the motor drive control system, including a hardware failure in the master control chip or a power supply failure of the master control chip, etc., the technical solution of the present application allows effective monitoring of whether the motor drive control system enters a corresponding safety status, which increases the factor of safety in the event of a failure in the motor drive control system and reduces the safety risk of the system.

### Brief Description of the Drawings

The accompanying drawings are intended to provide a further understanding of the present application and are incorporated into and constitute a part of the present application, show the embodiments of the present application, and serve to, together with the description, explain the principles of the present application. In the accompanying drawings:
FIG. 1 is a schematic diagram of the composition of a safety status monitoring system for a motor drive control system according to an embodiment of the present application;
FIG. 2 is a schematic diagram of the composition of a safety status monitoring system for a motor drive control system according to an embodiment of the present application;
FIG. 3 is a schematic diagram showing a numerical magnitude relationship between a bus voltage value of a motor drive control system and a set voltage threshold according to an embodiment of the present application; and
FIG. 4 is a flowchart of a safety status monitoring method for a motor drive control system according to an embodiment of the present application.

### Detailed Description of Embodiments

To describe technical solutions of embodiments of the present application more clearly, the accompanying drawings required for describing the embodiments will be briefly described below. Obviously, the accompanying drawings described below show merely some of the examples or embodiments of the present application, and those of ordinary skill in the art would also have applied the present application to other similar scenarios according to these accompanying drawings without involving any creative effort. Unless obvious from the language context or otherwise illustrated, the same reference numerals in the drawings represent the same structure or operation.

As shown in the present application and the claims, unless the context expressly indicates otherwise, the words "a", "an", "said", and/or "the" do not specifically refer to the singular, but may also include the plural. Generally, the terms "include" and "comprise" only suggest that the expressly identified steps and elements are included, but these steps and elements do not constitute an exclusive list, and the method or device may further include other steps or elements.

Unless otherwise indicated specifically, the relative arrangement, numerical expressions and values of the components and steps set forth in these embodiments do not limit the scope of the present application. In addition, it should be understood that, for ease of description, the dimensions of the various parts shown in the accompanying drawings are not drawn according to the actual proportional relationship. Techniques, methods and devices known to those of ordinary skill in the relevant field may not be discussed in detail, but where appropriate, the techniques, methods and devices should be considered as part of the authorized description. In all of the examples shown and discussed here, any specific value should be construed as merely exemplary but not limiting. Therefore, other examples of exemplary embodiments may have different values. It should be noted that similar reference signs and letters refer to similar items in the following drawings. Therefore, once an item is defined in one of the drawings, it is not necessary to further discuss the item in subsequent drawings.

The embodiments of the present application describe a safety status monitoring system and method for a motor drive control system.

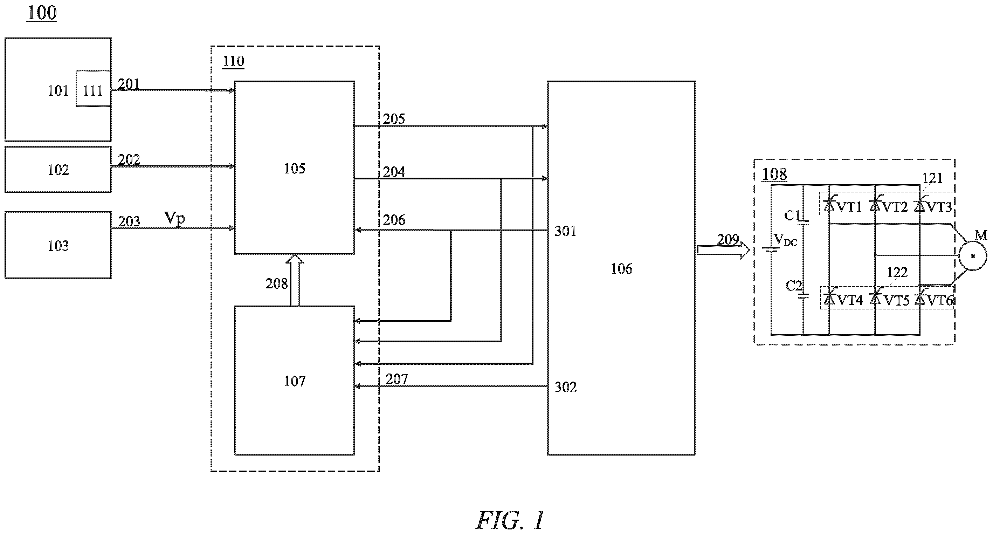

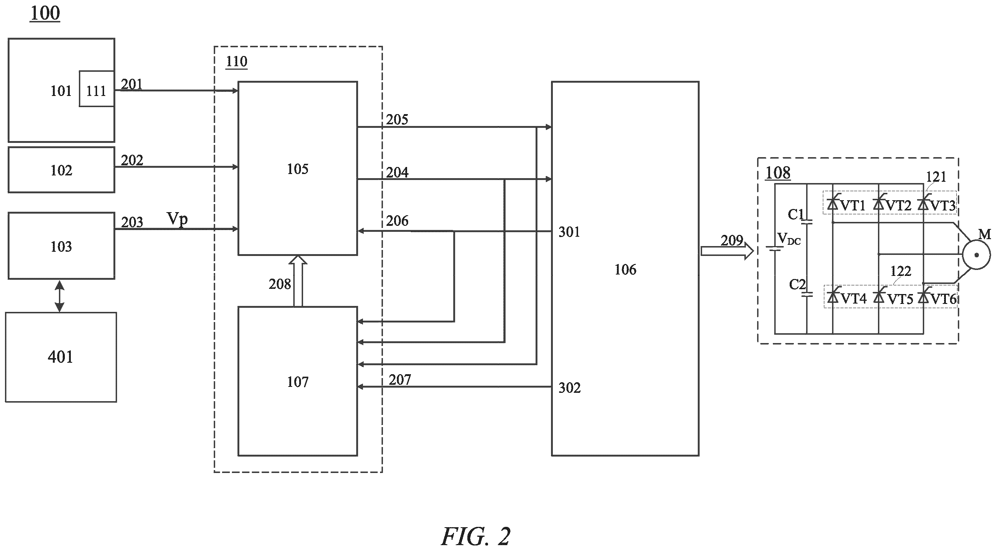

FIG. 1 is a schematic diagram of the composition of a safety status monitoring system for a motor drive control system according to an embodiment of the present application. FIG. 2 is a schematic diagram of the composition of a safety status monitoring system for a motor drive control system according to an embodiment of the present application.

With reference to FIG. 1 and FIG. 2, the safety status monitoring system 100 for the motor drive control system includes a master control chip 101, a power management chip 102, a bus voltage comparison module 103, a safety control logic generation module 105, a gate drive module 106, a drive safety status monitoring module 107, and a three-phase bridge switching circuit module 108.

In some embodiment, the master control chip 101 includes a hardware safety management unit 111. The hardware safety management unit 111 is configured to issue a master control chip hardware failure signal 201 based on specific signal detection and determination logic.

The power management chip 102 is configured to generate a safety status entry signal 202. The power management chip 102 may actually also supply power to the master control chip 101, and monitor the power supply operating status of the master control chip 101 to issue the safety status entry signal 202. The bus voltage comparison module 103 is configured to obtain a safety status switching signal 203 for the motor drive control system. Specifically, the bus voltage comparison module 103 obtains, for example, a bus voltage signal from a bus voltage sampling module 401 of the motor drive control system, and obtains the safety status switching signal 203 for the motor drive control system based on corresponding safety status determination logic. The motor drive control system includes, for example, the master control chip 101, the power management chip 102, the bus voltage sampling module 401, the gate drive module 106, the three-phase bridge switching circuit module 108, etc. The three-phase bridge switching circuit module 108 includes a plurality of power transistors, such as power transistors VT1, VT2, VT3, VT4, VT5, and VT6 in FIG. 1 and FIG. 2. The bus voltage is the voltage of a main battery (for example, a battery pack) that supplies power to the motor drive control system.

The safety control logic generation module 105 is configured to generate a hardware failure mode enable signal 204 and a hardware failure status control signal 205 based on the master control chip hardware failure signal 201, the safety status entry signal 202, and the safety status switching signal 203 for the motor drive control system. The gate drive module 106 is configured to generate a gate drive signal 209 based on the hardware failure mode enable signal 204 and the hardware failure status control signal 205 to perform turning-on and turning-off operations on the power transistors in the three-phase bridge switching circuit module 108, and output a gate drive module failure status signal 206 and a power transistor working status signal 207. The gate drive module failure status signal 206 and the power transistor working status signal 207 are specifically output, for example, via pins 301 and 302, respectively, of the gate drive module 106.

In some embodiments, the drive safety status monitoring module 107 is configured to generate a drive safety status feedback control signal 208 based on the hardware failure mode enable signal 204, the hardware failure status control signal 205, the gate drive module failure status signal 206, and the power transistor working status signal 207, and transmit the drive safety status feedback control signal to the safety control logic generation module 105.

The safety control logic generation module 105 is further, for example, configured to update the hardware failure status control signal 205 based on the drive safety status feedback control signal 208.

In some embodiments, the three-phase bridge switching circuit module 108 includes an upper three-bridge-arm circuit 121 and a lower three-bridge-arm circuit 122. Each bridge arm of the upper three-bridge-arm circuit 121 and the lower three-bridge-arm circuit 122 includes a power transistor, specifically for example, the power transistors VT1, VT2, and VT3 included in each bridge arm of the upper three-bridge-arm circuit 121, and the power transistors VT4, VT5, and VT6 included in each bridge arm of the lower three-bridge-arm circuit 122 in FIG. 2. The three-phase bridge switching circuit module 108 is connected to a load M. M is, for example, a motor drive-related load, which is driven by a three-phase voltage signal generated by the three-phase bridge switching circuit module 108.

In some embodiments, the generating a hardware failure mode enable signal 204 and a hardware failure status control signal 205 based on the master control chip hardware failure signal 201, the safety status entry signal 202, and the safety status switching signal 203 for the motor drive control system includes: when the safety control logic generation module 105 determines, based on the received master control chip hardware failure signal 201 and safety status entry signal 202, that a hardware failure and/or a power supply failure occurs in the master control chip 101, generating, by the safety control logic generation module 105 and based on a relationship between a bus voltage value Vp of the motor drive control system and a set voltage threshold Vth, the hardware failure mode enable signal 204 and the hardware failure status control signal 205 corresponding to turning off all the power transistors in the three-phase bridge switching circuit module 108 or turning on all power transistors in the lower three-bridge-arm circuit 122 of the three-phase bridge switching circuit module 108.

In some embodiment, the set voltage threshold Vth includes, for example, a first set voltage threshold Vth1 and a second set voltage threshold Vth2, and the second set voltage threshold Vth2 is greater than the first set voltage threshold Vth1.

When the bus voltage value Vp of the motor drive control system is less than the first set voltage threshold Vth1, the safety control logic generation module 105 generates the hardware failure status control signal 205 corresponding to turning off all the power transistors in the three-phase bridge switching circuit module 108. When the bus voltage value Vp of the motor drive control system is greater than the second set voltage threshold Vth2, the safety control logic generation module 105 generates the hardware failure status control signal 205 corresponding to turning on all the power transistors in the lower three-bridge-arm circuit 122 of the three-phase bridge switching circuit module 108. A numerical interval between the first set voltage threshold Vth1 and the second set voltage threshold Vth2 is a hysteresis interval.

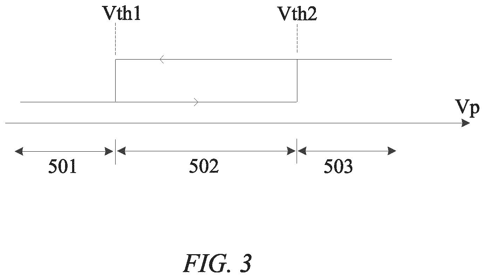

FIG. 3 is a schematic diagram showing a numerical magnitude relationship between the bus voltage value Vp of the motor drive control system and the set voltage threshold Vth according to an embodiment of the present application. With reference to FIG. 3, in the interval 501, in which when the bus voltage value Vp of the motor drive control system is less than the first set voltage threshold Vth1, the safety control logic generation module 105 generates the hardware failure status control signal 205 corresponding to turning off all the power transistors in the three-phase bridge switching circuit module 108. In the interval 503, in which when the bus voltage value Vp of the motor drive control system is greater than the second set voltage threshold Vth2, the safety control logic generation module 105 generates the hardware failure status control signal 205 corresponding to turning on all the power transistors in the lower three-bridge-arm circuit 122 of the three-phase bridge switching circuit module 108. The interval 502 corresponds to the hysteresis interval, in which when the bus voltage value Vp of the motor drive control system changes from being greater than the second set voltage threshold Vth2 to being less than the second set voltage threshold Vth2 but still greater than the first set voltage threshold Vth1, the safety control logic generation module 105 still generates the hardware failure status control signal 205 corresponding to turning on all the power transistors in the lower three-bridge-arm circuit 122 of the three-phase bridge switching circuit module 108; or when the bus voltage value Vp of the motor drive control system changes from being less than the first set voltage threshold Vth1 to being greater than the second set voltage threshold Vth1 but still less than the second set voltage threshold Vth2, the safety control logic generation module 105 still generates the hardware failure status control signal 205 corresponding to turning off all the power transistors in the three-phase bridge switching circuit module 108.

In some embodiments, the drive safety status monitoring module 107 is configured to generate the drive safety status feedback control signal 208 after a specific time interval t1 and based on the hardware failure mode enable signal 204, the hardware failure status control signal 205, the gate drive module failure status signal 206, and the power transistor working status signal 207, and transmit the drive safety status feedback control signal to the safety control logic generation module 105. The specific time interval t1 is, for example, 50 microseconds, 100 microseconds, 200 microseconds, etc.

In some embodiments, the generating a drive safety status feedback control signal 208 based on the hardware failure mode enable signal 204, the hardware failure status control signal 205, the gate drive module failure status signal 206, and the power transistor working status signal 207 includes: when the drive safety status monitoring module 107 determines, based on the gate drive module failure status signal 206 and power transistor working status signal 207 of a current cycle, that the three-phase bridge switching circuit module 108 does not enter a safety status corresponding to the hardware failure status control signal 205 of a previous clock cycle, updating the hardware failure status control signal 205 based on the gate drive module failure status signal 206 and power transistor working status signal 207 of the current cycle, to generate the drive safety status feedback control signal 208.

The updating the hardware failure status control signal 205 of the current cycle based on the gate drive module failure status signal 206 and power transistor working status signal 207 of the current cycle includes, for example: when the hardware failure status control signal 205 of the previous clock cycle is the hardware failure status control signal 205 corresponding to turning off all the power transistors in the three-phase bridge switching circuit module 108, and when the drive safety status monitoring module 107 determines, based on the gate drive module failure status signal 206 and power transistor working status signal 207 of the current cycle, that the three-phase bridge switching circuit module 108 does not enter a safety status corresponding to turning off all the power transistors in the three-phase bridge switching circuit module 108, updating the hardware failure status control signal 205 based on the gate drive module failure status signal 206 and power transistor working status signal 207 of the current cycle, to generate, as the drive safety status feedback control signal 208, the hardware failure status control signal 205 corresponding to turning on all power transistors in the upper three-bridge-arm circuit 121 or the lower three-bridge-arm circuit 122 of the three-phase bridge switching circuit module 108.

In some embodiments, the gate drive module failure status signal 206 corresponding to the three-phase bridge switching circuit module 108 includes: a gate drive module failure status signal 206 for a failed drive component corresponding to the upper three-bridge-arm circuit 121 or the lower three-bridge-arm circuit 122 of the three-phase bridge switching circuit module 108. The power transistor working status signal 207 is generated based on a turn-on voltage detection value Vce of the power transistor.

In some embodiments, the updating the hardware failure status control signal 205 based on the gate drive module failure status signal 206 and power transistor working status signal 207 of the current cycle, to generate, as the drive safety status feedback control signal 208, the hardware failure status control signal 205 corresponding to turning on all power transistors in the upper three-bridge-arm circuit 121 or the lower three-bridge-arm circuit 122 of the three-phase bridge switching circuit module 108 includes: when a short circuit failure occurs in a power transistor of one bridge arm in the upper three-bridge-arm circuit 121 of the three-phase bridge switching circuit module 108, generating, as the drive safety status feedback control signal 208, the hardware failure status control signal 205 corresponding to turning on all the power transistors in the upper three-bridge-arm circuit 121 of the three-phase bridge switching circuit module 108.

The updating the hardware failure status control signal 205 based on the gate drive module failure status signal 206 and power transistor working status signal 207 of the current cycle, to generate, as the drive safety status feedback control signal 208, the hardware failure status control signal 205 corresponding to turning on all power transistors in the upper three-bridge-arm circuit 121 or the lower three-bridge-arm circuit 122 of the three-phase bridge switching circuit module 108 further includes, for example: when the three-phase bridge switching circuit module 108 cannot to enter the status for turning on all the power transistors in the upper three-bridge-arm circuit 121 of the three-phase bridge switching circuit module 108 due to an open circuit failure in the power transistor of one bridge arm in the upper three-bridge-arm circuit 121 of the three-phase bridge switching circuit module, generating, as the drive safety status feedback control signal 208, the hardware failure status control signal 205 corresponding to turning on all the power transistors in the lower three-bridge-arm circuit 122 of the three-phase bridge switching circuit module 108.

In some other embodiments, the updating the hardware failure status control signal 205 based on the gate drive module failure status signal 206 and power transistor working status signal 207 of the current cycle, to generate, as the drive safety status feedback control signal 208, the hardware failure status control signal 205 corresponding to turning on all power transistors in the upper three-bridge-arm circuit 121 or the lower three-bridge-arm circuit 122 of the three-phase bridge switching circuit module 108 includes, for example: when a short circuit failure occurs in a power transistor of one bridge arm in the lower three-bridge-arm circuit 122 of the three-phase bridge switching circuit module 108, generating, as the drive safety status feedback control signal 208, the hardware failure status control signal 205 corresponding to turning on all the power transistors in the lower three-bridge-arm circuit 122 of the three-phase bridge switching circuit module 108.

The updating the hardware failure status control signal 205 based on the gate drive module failure status signal 206 and power transistor working status signal 207 of the current cycle, to generate, as the drive safety status feedback control signal 208, the hardware failure status control signal 205 corresponding to turning on all power transistors in the upper three-bridge-arm circuit 121 or the lower three-bridge-arm circuit 122 of the three-phase bridge switching circuit module 108 further includes, for example: when the three-phase bridge switching circuit module 108 cannot to enter the status for turning on all the power transistors in the lower three-bridge-arm circuit 122 of the three-phase bridge switching circuit module 108 due to an open circuit failure in the power transistor of one bridge arm in the lower three-bridge-arm circuit 122 of the three-phase bridge switching circuit module, generating, as the drive safety status feedback control signal 208, the hardware failure status control signal 205 corresponding to turning on all the power transistors in the upper three-bridge-arm circuit 121 of the three-phase bridge switching circuit module 108.

In some embodiments, the updating the hardware failure status control signal 205 based on the gate drive module failure status signal 206 and power transistor working status signal 207 of the current cycle, to generate, as the drive safety status feedback control signal 208, the hardware failure status control signal 205 corresponding to turning on all power transistors in the upper three-bridge-arm circuit 121 or the lower three-bridge-arm circuit 122 of the three-phase bridge switching circuit module 108 includes: when a short circuit failure occurs in a power transistor of one bridge arm in the upper three-bridge-arm circuit 121 of the three-phase bridge switching circuit module 108 and when a short circuit failure occurs in a power transistor of one bridge arm in the lower three-bridge-arm circuit 122 of the three-phase bridge switching circuit module, maintaining the current hardware failure status control signal 205 as the drive safety status feedback control signal 208.

In some embodiments, the updating the hardware failure status control signal 205 of the current cycle based on the gate drive module failure status signal 206 and power transistor working status signal 207 of the current cycle includes: when the hardware failure status control signal 205 of the previous clock cycle is the hardware failure status control signal 205 corresponding to turning on all the power transistors in the lower three-bridge-arm circuit 122 of the three-phase bridge switching circuit module 108, and when the drive safety status monitoring module 107 determines, based on the gate drive module failure status signal 206 and power transistor working status signal 207 of the current cycle, that the three-phase bridge switching circuit module 108 does not enter a safety status corresponding to turning on all the power transistors in the lower three-bridge-arm circuit 122 of the three-phase bridge switching circuit module 108, updating the hardware failure status control signal 205 as the drive safety status feedback control signal 208 based on the gate drive module failure status signal 206 and power transistor working status signal 207 of the current cycle.

In some embodiments, the updating the hardware failure status control signal 205 as the drive safety status feedback control signal 208 based on the gate drive module failure status signal 206 and power transistor working status signal 207 of the current cycle includes, for example: when an open circuit failure occurs in a power transistor of one bridge arm in the lower three-bridge-arm circuit 122 of the three-phase bridge switching circuit module 108, generating, as the drive safety status feedback control signal 208, the hardware failure status control signal 205 corresponding to turning on all the power transistors in the upper three-bridge-arm circuit 121 of the three-phase bridge switching circuit module 108.

In the event of a hardware failure in the motor drive control system, including a hardware failure in the master control chip or a power supply failure of the master control chip, etc., the safety status monitoring system for a motor drive control system of the present application allows effective monitoring of whether the motor drive control system enters a corresponding safety status, which increases the factor of safety in the event of a failure in the motor drive control system and reduces the safety risk of the system.

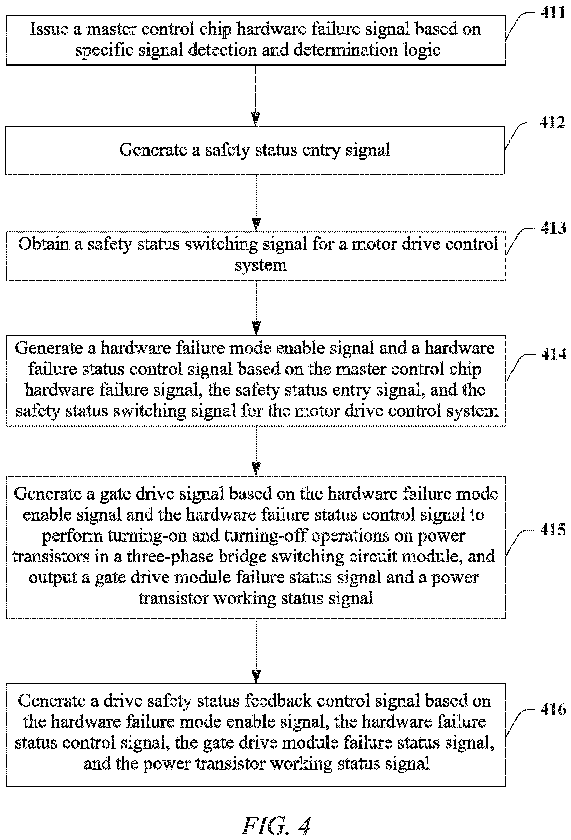

The present application further provides a safety status monitoring method for a motor drive control system. FIG. 4 is a flowchart of a safety status monitoring method for a motor drive control system according to an embodiment of the present application. With reference to FIG. 4, the safety status monitoring method for a motor drive control system includes: step 411 of issuing a master control chip hardware failure signal based on specific signal detection and determination logic; step 412 of generating a safety status entry signal; step 413 of obtaining a safety status switching signal for the motor drive control system; step 414 of generating a hardware failure mode enable signal and a hardware failure status control signal based on the master control chip hardware failure signal, the safety status entry signal, and the safety status switching signal for the motor drive control system; step 415 of generating a gate drive signal based on the hardware failure mode enable signal and the hardware failure status control signal to perform turning-on and turning-off operations on power transistors in a three-phase bridge switching circuit module, and outputting a gate drive module failure status signal and a power transistor working status signal; and step 416 of generating a drive safety status feedback control signal based on the hardware failure mode enable signal, the hardware failure status control signal, the gate drive module failure status signal, and the power transistor working status signal.

In some embodiments, in addition to steps 411 to 416 as described above, the safety status monitoring method for a motor drive control system further includes a step 417 of updating the hardware failure status control signal based on the drive safety status feedback control signal. For detailed implementation of steps 411 to 416, reference may be made to the foregoing description, which will not be described herein again.

The technical solution of the present application makes it possible to avoid the case where the three-phase bridge switching circuit module cannot enter a target safety status in which all the power transistors in the three-phase bridge switching circuit module are turned off or all the power transistors in the upper three-bridge-arm circuit or the lower three-bridge-arm circuit of the three-phase bridge switching circuit module are turned on, thereby preventing an extremely high short-circuit current or voltage from flowing back into a circuit loop of the motor drive control system, which may cause damage to components and result in a potential safety risk. In addition, the working and operation of the drive safety status monitoring module enables the motor drive control system to effectively enter the corresponding safety status, thereby reducing the safety risk in the event of a failure in the motor drive control system.

The basic concepts have been described above. Obviously, for those skilled in the art, the above disclosure of the present invention is merely used as an example and does not constitute a limitation on the present application. Although not explicitly stated herein, various modifications, improvements and amendments may be made to the present application by those skilled in the art. Such modifications, improvements and amendments are suggested in the present application, and therefore, such modifications, improvements and amendments still fall within the spirit and scope of the exemplary embodiments of the present application.

Meanwhile, the present application uses specific terms to describe the embodiments of the present application. For example, "one embodiment", "an embodiment", and/or "some embodiments" mean a feature, structure, or characteristic associated with at least one embodiment of the present application. Therefore, it should be emphasized and noted that two or more references to "an embodiment" or "one embodiment" or "an alternative embodiment" in various places in this specification do not necessarily indicate the same embodiment. Furthermore, some features, structures, or characteristics of the one or more embodiments of the present application may be combined appropriately.

Some aspects of the present application may be completely executed by hardware, or may be completely executed by software (including firmware, resident software, microcode, etc.), or may be executed by a combination of hardware and software. The hardware or software described above may all be referred to as "data block", "module", "engine", "unit", "component", or "system". The processor may be one or more application-specific integrated circuits (ASICs), digital signal processors (DSPs), digital signal processing devices (DSPDs), programmable logic devices (PLDs), field-programmable gate arrays (FPGAs), processors, controllers, microcontrollers, microprocessors, or a combination thereof.

Similarly, it should be noted that to simplify the expressions in the disclosure of the present application to assist in the understanding of one or more embodiments of the present invention, a plurality of features may sometimes be incorporated into an embodiment and accompanying drawing, or a description thereof in the foregoing description of the embodiments of the present application. However, such a method of disclosure does not mean that the subject of the present application requires more features than those mentioned in the claims. In fact, the features of the embodiments are less than all the features of a single embodiment disclosed above.

Figures for describing the quantity of components and attributes are used in some embodiments. It should be understood that such figures for use in the description of the embodiments are modified with modifiers "about," "approximately," or "substantially" in some examples. Unless otherwise specified, "about," "approximately," or "substantially" indicates that a variation of ± 20% is allowed for the figures. Accordingly, in some embodiments, numerical parameters used in the description and the claims are all approximations, which can change depending on desired characteristics of individual embodiments. In some embodiments, for the numerical parameters, a specified number of valid digits should be considered, and a general bit retention method is used. Although numerical fields and parameters used to confirm the breadth of their ranges in some embodiments of the present application are approximations, such values are set to the extent practicable as precisely as possible in specific embodiments.

While the present application has been described with reference to the specific embodiments at hand, those of ordinary skill in the art would realize that the above embodiments are merely used to illustrate the present application, and various equivalent changes or substitutions can also be made without departing from the spirit of the present application. Therefore, any change and variation made to the above embodiments within the substantial spirit and scope of the present application shall fall within the scope of the claims of present application.

## Claims

1. A safety status monitoring system for a motor drive control system, **characterized in that** the safety status monitoring system comprises:
a master control chip comprising a hardware safety management unit configured to issue a master control chip hardware failure signal based on specific signal detection and determination logic;
a power management chip configured to generate a safety status entry signal;
a bus voltage comparison module configured to obtain a safety status switching signal for the motor drive control system;
a three-phase bridge switching circuit module comprising a plurality of power transistors;
a safety control logic generation module configured to generate a hardware failure mode enable signal and a hardware failure status control signal based on the master control chip hardware failure signal, the safety status entry signal, and the safety status switching signal for the motor drive control system;
a gate drive module configured to generate a gate drive signal based on the hardware failure mode enable signal and the hardware failure status control signal to perform turning-on and turning-off operations on the power transistors in the three-phase bridge switching circuit module, and output a gate drive module failure status signal and a power transistor working status signal; and
a drive safety status monitoring module configured to generate a drive safety status feedback control signal based on the hardware failure mode enable signal, the hardware failure status control signal, the gate drive module failure status signal, and the power transistor working status signal, and transmit the drive safety status feedback control signal to the safety control logic generation module.

2. The safety status monitoring system for a motor drive control system according to claim 1, **characterized in that** the safety control logic generation module is further configured to update the hardware failure status control signal based on the drive safety status feedback control signal.

3. The safety status monitoring system for a motor drive control system according to claim 1, **characterized in that** the three-phase bridge switching circuit module comprises an upper three-bridge-arm circuit and a lower three-bridge-arm circuit; and each bridge arm of the upper three-bridge-arm circuit and the lower three-bridge-arm circuit comprises a power transistor.

4. The safety status monitoring system for a motor drive control system according to claim 3, **characterized in that** the generating a hardware failure mode enable signal and a hardware failure status control signal based on the master control chip hardware failure signal, the safety status entry signal, and the safety status switching signal for the motor drive control system comprises:
when the safety control logic generation module determines, based on the received master control chip hardware failure signal and safety status entry signal, that a hardware failure and/or a power supply failure occurs in the master control chip,
generating, by the safety control logic generation module and based on a relationship between a bus voltage value of the motor drive control system and a set voltage threshold, the hardware failure mode enable signal and the hardware failure status control signal corresponding to turning off all the power transistors in the three-phase bridge switching circuit module or turning on all power transistors in the lower three-bridge-arm circuit of the three-phase bridge switching circuit module.

5. The safety status monitoring system for a motor drive control system according to claim 4, **characterized in that** the set voltage threshold comprises a first set voltage threshold and a second set voltage threshold, and the second set voltage threshold is greater than the first set voltage threshold;
when the bus voltage value of the motor drive control system is less than the first set voltage threshold, the safety control logic generation module generates the hardware failure status control signal corresponding to turning off all the power transistors in the three-phase bridge switching circuit module;
when the bus voltage value of the motor drive control system is greater than the second set voltage threshold, the safety control logic generation module generates the hardware failure status control signal corresponding to turning on all the power transistors in the lower three-bridge-arm circuit of the three-phase bridge switching circuit module; and
a numerical interval between the first set voltage threshold and the second set voltage threshold is a hysteresis interval.

6. The safety status monitoring system for a motor drive control system according to claim 5, **characterized in that** the generating a drive safety status feedback control signal based on the hardware failure mode enable signal, the hardware failure status control signal, the gate drive module failure status signal, and the power transistor working status signal comprises:
when the drive safety status monitoring module determines, based on the gate drive module failure status signal and power transistor working status signal of a current cycle, that the three-phase bridge switching circuit module does not enter a safety status corresponding to the hardware failure status control signal of a previous clock cycle,
updating the hardware failure status control signal based on the gate drive module failure status signal and power transistor working status signal of the current cycle, to generate the drive safety status feedback control signal.

7. The safety status monitoring system for a motor drive control system according to claim 6, **characterized in that** the updating the hardware failure status control signal of the current cycle based on the gate drive module failure status signal and power transistor working status signal of the current cycle comprises:
when the hardware failure status control signal of the previous clock cycle is the hardware failure status control signal corresponding to turning off all the power transistors in the three-phase bridge switching circuit module, and when the drive safety status monitoring module determines, based on the gate drive module failure status signal and power transistor working status signal of the current cycle, that the three-phase bridge switching circuit module does not enter a safety status corresponding to turning off all the power transistors in the three-phase bridge switching circuit module,
updating the hardware failure status control signal based on the gate drive module failure status signal and power transistor working status signal of the current cycle, to generate, as the drive safety status feedback control signal, the hardware failure status control signal corresponding to turning on all power transistors in the upper three-bridge-arm circuit or the lower three-bridge-arm circuit of the three-phase bridge switching circuit module.

8. The safety status monitoring system for a motor drive control system according to claim 7, **characterized in that** the updating the hardware failure status control signal based on the gate drive module failure status signal and power transistor working status signal of the current cycle, to generate, as the drive safety status feedback control signal, the hardware failure status control signal corresponding to turning on all power transistors in the upper three-bridge-arm circuit or the lower three-bridge-arm circuit of the three-phase bridge switching circuit module comprises:
when a short circuit failure occurs in a power transistor of one bridge arm in the upper three-bridge-arm circuit of the three-phase bridge switching circuit module, generating, as the drive safety status feedback control signal, the hardware failure status control signal corresponding to turning on all the power transistors in the upper three-bridge-arm circuit of the three-phase bridge switching circuit module.

9. The safety status monitoring system for a motor drive control system according to claim 7, **characterized in that** the updating the hardware failure status control signal based on the gate drive module failure status signal and power transistor working status signal of the current cycle, to generate, as the drive safety status feedback control signal, the hardware failure status control signal corresponding to turning on all power transistors in the upper three-bridge-arm circuit or the lower three-bridge-arm circuit of the three-phase bridge switching circuit module comprises:
when a short circuit failure occurs in a power transistor of one bridge arm in the lower three-bridge-arm circuit of the three-phase bridge switching circuit module, generating, as the drive safety status feedback control signal, the hardware failure status control signal corresponding to turning on all the power transistors in the lower three-bridge-arm circuit of the three-phase bridge switching circuit module.

10. The safety status monitoring system for a motor drive control system according to claim 8, **characterized in that** the updating the hardware failure status control signal based on the gate drive module failure status signal and power transistor working status signal of the current cycle, to generate, as the drive safety status feedback control signal, the hardware failure status control signal corresponding to turning on all power transistors in the upper three-bridge-arm circuit or the lower three-bridge-arm circuit of the three-phase bridge switching circuit module further comprises:
when the three-phase bridge switching circuit module cannot to enter the status for turning on all the power transistors in the upper three-bridge-arm circuit of the three-phase bridge switching circuit module due to an open circuit failure in the power transistor of one bridge arm in the upper three-bridge-arm circuit of the three-phase bridge switching circuit module, generating, as the drive safety status feedback control signal, the hardware failure status control signal corresponding to turning on all the power transistors in the lower three-bridge-arm circuit of the three-phase bridge switching circuit module.

11. The safety status monitoring system for a motor drive control system according to claim 9, **characterized in that** the updating the hardware failure status control signal based on the gate drive module failure status signal and power transistor working status signal of the current cycle, to generate, as the drive safety status feedback control signal, the hardware failure status control signal corresponding to turning on all power transistors in the upper three-bridge-arm circuit or the lower three-bridge-arm circuit of the three-phase bridge switching circuit module further comprises:
when the three-phase bridge switching circuit module cannot to enter the status for turning on all the power transistors in the lower three-bridge-arm circuit of the three-phase bridge switching circuit module due to an open circuit failure in the power transistor of one bridge arm in the lower three-bridge-arm circuit of the three-phase bridge switching circuit module, generating, as the drive safety status feedback control signal, the hardware failure status control signal corresponding to turning on all the power transistors in the upper three-bridge-arm circuit of the three-phase bridge switching circuit module.

12. The safety status monitoring system for a motor drive control system according to claim 7, **characterized in that** the updating the hardware failure status control signal based on the gate drive module failure status signal and power transistor working status signal of the current cycle, to generate, as the drive safety status feedback control signal, the hardware failure status control signal corresponding to turning on all power transistors in the upper three-bridge-arm circuit or the lower three-bridge-arm circuit of the three-phase bridge switching circuit module comprises:
when a short circuit failure occurs in a power transistor of one bridge arm in the upper three-bridge-arm circuit of the three-phase bridge switching circuit module and when a short circuit failure occurs in a power transistor of one bridge arm in the lower three-bridge-arm circuit of the three-phase bridge switching circuit module, maintaining the current hardware failure status control signal as the drive safety status feedback control signal.

13. The safety status monitoring system for a motor drive control system according to claim 6, **characterized in that** the updating the hardware failure status control signal of the current cycle based on the gate drive module failure status signal and power transistor working status signal of the current cycle comprises:
when the hardware failure status control signal of the previous clock cycle is the hardware failure status control signal corresponding to turning on all the power transistors in the lower three-bridge-arm circuit of the three-phase bridge switching circuit module, and when the drive safety status monitoring module determines, based on the gate drive module failure status signal and power transistor working status signal of the current cycle, that the three-phase bridge switching circuit module does not enter a safety status corresponding to turning on all the power transistors in the lower three-bridge-arm circuit of the three-phase bridge switching circuit module,
updating the hardware failure status control signal as the drive safety status feedback control signal based on the gate drive module failure status signal and power transistor working status signal of the current cycle.

14. The safety status monitoring system for a motor drive control system according to claim 13, **characterized in that** the updating the hardware failure status control signal as the drive safety status feedback control signal based on the gate drive module failure status signal and power transistor working status signal of the current cycle comprises:
when an open circuit failure occurs in a power transistor of one bridge arm in the lower three-bridge-arm circuit of the three-phase bridge switching circuit module, generating, as the drive safety status feedback control signal, the hardware failure status control signal corresponding to turning on all the power transistors in the upper three-bridge-arm circuit of the three-phase bridge switching circuit module.

15. The safety status monitoring system for a motor drive control system according to claim 1, **characterized in that** the drive safety status monitoring module is configured to generate the drive safety status feedback control signal after a specific time interval and based on the hardware failure mode enable signal, the hardware failure status control signal, the gate drive module failure status signal, and the power transistor working status signal, and transmit the drive safety status feedback control signal to the safety control logic generation module.

16. The safety status monitoring system for a motor drive control system according to claim 3, **characterized in that** the gate drive module failure status signal corresponding to the three-phase bridge switching circuit module comprises: a gate drive module failure status signal for a failed drive component corresponding to the upper three-bridge-arm circuit or the lower three-bridge-arm circuit of the three-phase bridge switching circuit module.

17. The safety status monitoring system for a motor drive control system according to claim 1, **characterized in that** the power transistor working status signal is generated based on a turn-on voltage detection value of the power transistor.

18. A safety status monitoring method for a motor drive control system, **characterized in that** the method comprises:
issuing a master control chip hardware failure signal based on specific signal detection and determination logic;
generating a safety status entry signal;
obtaining a safety status switching signal for the motor drive control system;
generating a hardware failure mode enable signal and a hardware failure status control signal based on the master control chip hardware failure signal, the safety status entry signal, and the safety status switching signal for the motor drive control system;
generating a gate drive signal based on the hardware failure mode enable signal and the hardware failure status control signal to perform turning-on and turning-off operations on power transistors in a three-phase bridge switching circuit module, and outputting a gate drive module failure status signal and a power transistor working status signal; and
generating a drive safety status feedback control signal based on the hardware failure mode enable signal, the hardware failure status control signal, the gate drive module failure status signal, and the power transistor working status signal.

19. The safety status monitoring method for a motor drive control system according to claim 18, **characterized in that** the method further comprises: updating the hardware failure status control signal based on the drive safety status feedback control signal.

20. The safety status monitoring method for a motor drive control system according to claim 18, **characterized in that** the generating a hardware failure mode enable signal and a hardware failure status control signal based on the master control chip hardware failure signal, the safety status entry signal, and the safety status switching signal for the motor drive control system comprises:
when it is determined, based on the master control chip hardware failure signal and the safety status entry signal, that a hardware failure and/or a power supply failure occurs in the master control chip,
generating, based on a relationship between a bus voltage value of the motor drive control system and a set voltage threshold, the hardware failure mode enable signal and the hardware failure status control signal corresponding to turning off all the power transistors in the three-phase bridge switching circuit module or turning on all power transistors in a lower three-bridge-arm circuit of the three-phase bridge switching circuit module.

21. The safety status monitoring method for a motor drive control system according to claim 20, **characterized in that** the set voltage threshold comprises a first set voltage threshold and a second set voltage threshold, and the second set voltage threshold is greater than the first set voltage threshold;
when the bus voltage value of the motor drive control system is less than the first set voltage threshold, the hardware failure status control signal corresponding to turning off all the power transistors in the three-phase bridge switching circuit module is generated;
when the bus voltage value of the motor drive control system is greater than the second set voltage threshold, the hardware failure status control signal corresponding to turning on all the power transistors in the lower three-bridge-arm circuit of the three-phase bridge switching circuit module is generated; and
a numerical interval between the first set voltage threshold and the second set voltage threshold is a hysteresis interval.

22. The safety status monitoring method for a motor drive control system according to claim 21, **characterized in that** the generating a drive safety status feedback control signal based on the hardware failure mode enable signal, the hardware failure status control signal, the gate drive module failure status signal, and the power transistor working status signal comprises:
when it is determined, based on the gate drive module failure status signal and power transistor working status signal of a current cycle, that the three-phase bridge switching circuit module does not enter a safety status corresponding to the hardware failure status control signal of a previous clock cycle,
updating the hardware failure status control signal based on the gate drive module failure status signal and power transistor working status signal of the current cycle, to generate the drive safety status feedback control signal.

23. The safety status monitoring method for a motor drive control system according to claim 22, **characterized in that** the updating the hardware failure status control signal of the current cycle based on the gate drive module failure status signal and power transistor working status signal of the current cycle comprises:
when the hardware failure status control signal of the previous clock cycle is the hardware failure status control signal corresponding to turning off all the power transistors in the three-phase bridge switching circuit module, and when the drive safety status monitoring module determines, based on the gate drive module failure status signal and power transistor working status signal of the current cycle, that the three-phase bridge switching circuit module does not enter a safety status corresponding to turning off all the power transistors in the three-phase bridge switching circuit module,
updating the hardware failure status control signal based on the gate drive module failure status signal and power transistor working status signal of the current cycle, to generate, as the drive safety status feedback control signal, the hardware failure status control signal corresponding to turning on all power transistors in the upper three-bridge-arm circuit or the lower three-bridge-arm circuit of the three-phase bridge switching circuit module.

24. The safety status monitoring method for a motor drive control system according to claim 23, **characterized in that** the updating the hardware failure status control signal based on the gate drive module failure status signal and power transistor working status signal of the current cycle, to generate, as the drive safety status feedback control signal, the hardware failure status control signal corresponding to turning on all power transistors in the upper three-bridge-arm circuit or the lower three-bridge-arm circuit of the three-phase bridge switching circuit module comprises:
when a short circuit failure occurs in a power transistor of one bridge arm in the upper three-bridge-arm circuit of the three-phase bridge switching circuit module, generating, as the drive safety status feedback control signal, the hardware failure status control signal corresponding to turning on all the power transistors in the upper three-bridge-arm circuit of the three-phase bridge switching circuit module.

25. The safety status monitoring method for a motor drive control system according to claim 23, **characterized in that** the updating the hardware failure status control signal based on the gate drive module failure status signal and power transistor working status signal of the current cycle, to generate, as the drive safety status feedback control signal, the hardware failure status control signal corresponding to turning on all power transistors in the upper three-bridge-arm circuit or the lower three-bridge-arm circuit of the three-phase bridge switching circuit module comprises:
when a short circuit failure occurs in a power transistor of one bridge arm in the lower three-bridge-arm circuit of the three-phase bridge switching circuit module, generating, as the drive safety status feedback control signal, the hardware failure status control signal corresponding to turning on all the power transistors in the lower three-bridge-arm circuit of the three-phase bridge switching circuit module.

26. The safety status monitoring method for a motor drive control system according to claim 24, **characterized in that** the updating the hardware failure status control signal based on the gate drive module failure status signal and power transistor working status signal of the current cycle, to generate, as the drive safety status feedback control signal, the hardware failure status control signal corresponding to turning on all power transistors in the upper three-bridge-arm circuit or the lower three-bridge-arm circuit of the three-phase bridge switching circuit module further comprises:
when the three-phase bridge switching circuit module cannot to enter the status for turning on all the power transistors in the upper three-bridge-arm circuit of the three-phase bridge switching circuit module due to an open circuit failure in the power transistor of one bridge arm in the upper three-bridge-arm circuit of the three-phase bridge switching circuit module, generating, as the drive safety status feedback control signal, the hardware failure status control signal corresponding to turning on all the power transistors in the lower three-bridge-arm circuit of the three-phase bridge switching circuit module.

27. The safety status monitoring method for a motor drive control system according to claim 25, **characterized in that** the updating the hardware failure status control signal based on the gate drive module failure status signal and power transistor working status signal of the current cycle, to generate, as the drive safety status feedback control signal, the hardware failure status control signal corresponding to turning on all power transistors in the upper three-bridge-arm circuit or the lower three-bridge-arm circuit of the three-phase bridge switching circuit module further comprises:
when the three-phase bridge switching circuit module cannot to enter the status for turning on all the power transistors in the lower three-bridge-arm circuit of the three-phase bridge switching circuit module due to an open circuit failure in the power transistor of one bridge arm in the lower three-bridge-arm circuit of the three-phase bridge switching circuit module, generating, as the drive safety status feedback control signal, the hardware failure status control signal corresponding to turning on all the power transistors in the upper three-bridge-arm circuit of the three-phase bridge switching circuit module.

28. The safety status monitoring method for a motor drive control system according to claim 23, **characterized in that** the updating the hardware failure status control signal based on the gate drive module failure status signal and power transistor working status signal of the current cycle, to generate, as the drive safety status feedback control signal, the hardware failure status control signal corresponding to turning on all power transistors in the upper three-bridge-arm circuit or the lower three-bridge-arm circuit of the three-phase bridge switching circuit module comprises:
when a short circuit failure occurs in a power transistor of one bridge arm in the upper three-bridge-arm circuit of the three-phase bridge switching circuit module and when a short circuit failure occurs in a power transistor of one bridge arm in the lower three-bridge-arm circuit of the three-phase bridge switching circuit module, maintaining the current hardware failure status control signal as the drive safety status feedback control signal.

29. The safety status monitoring method for a motor drive control system according to claim 22, **characterized in that** the updating the hardware failure status control signal of the current cycle based on the gate drive module failure status signal and power transistor working status signal of the current cycle comprises:
when the hardware failure status control signal of the previous clock cycle is the hardware failure status control signal corresponding to turning on all the power transistors in the lower three-bridge-arm circuit of the three-phase bridge switching circuit module, and when the drive safety status monitoring module determines, based on the gate drive module failure status signal and power transistor working status signal of the current cycle, that the three-phase bridge switching circuit module does not enter a safety status corresponding to turning on all the power transistors in the lower three-bridge-arm circuit of the three-phase bridge switching circuit module,
updating the hardware failure status control signal as the drive safety status feedback control signal based on the gate drive module failure status signal and power transistor working status signal of the current cycle.

30. The safety status monitoring method for a motor drive control system according to claim 29, **characterized in that** the updating the hardware failure status control signal as the drive safety status feedback control signal based on the gate drive module failure status signal and power transistor working status signal of the current cycle comprises:
when an open circuit failure occurs in a power transistor of one bridge arm in the lower three-bridge-arm circuit of the three-phase bridge switching circuit module, generating, as the drive safety status feedback control signal, the hardware failure status control signal corresponding to turning on all the power transistors in the upper three-bridge-arm circuit of the three-phase bridge switching circuit module.
